(19) Europäisches Patentamt / European Patent Office / Office européen des brevets

(11) **EP 3 565 146 A1**

(12) **EUROPEAN PATENT APPLICATION**

(43) Date of publication:
06.11.2019 Bulletin 2019/45

(51) Int Cl.:
*H04B 17/318* (2015.01)     *G01R 23/00* (2006.01)

(21) Application number: 18275061.2

(22) Date of filing: 30.04.2018

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **MBDA UK Limited**
**Stevenage, Hertfordshire SG1 2DA (GB)**

(72) Inventor: **The designation of the inventor has not yet been filed**

(74) Representative: **BAE SYSTEMS plc**
**Group IP Department**
**Farnborough Aerospace Centre**
**Farnborough**
**Hampshire GU14 6YU (GB)**

(54) **DETECTION OF RF SIGNAL FREQUENCY**

(57)     In a method of detecting one or more frequencies in an RF signal, the RF signal is down-converted. A Fast Fourier Transform is performed on the down-converted RF signal to measure the strength of the RF signal in each of a plurality of frequency bins each covering a range of frequencies. The frequency bin in which the RF signal is strongest is identified. The strength of the RF signal in a bin covering frequencies below the frequencies covered by the bin in which the RF signal is strongest is compared with the strength of the RF signal in a bin above the frequencies covered by the bin in which the RF signal in strongest. A frequency of the RF signal is calculated from the strength of the signal in the bin in which the RF signal is strongest and the strength of the RF signal in said bin above and/or below.

Fig. 5(b)

**Description**

FIELD OF THE INVENTION

This invention relates to the field of RF signal processing, and in particular to detecting one or more frequencies in an RF signal.

BACKGROUND ART

A Fast Fourier Transform (FFT) can be applied to a (time varying) signal to obtain the frequency spectrum of the signal. The spectrum provided by the FFT has a frequency resolution that is governed by the sample periods used in the FFT to collect the signal. The frequency resolution is the reciprocal of the sample time so, for example, a 16 ns sample period yields a frequency resolution of 62.5 MHz; a 32 ns sample period yields a frequency resolution of 31.25 MHz, and a 64 ns sample period yields a frequency resolution of 15.625 MHz. The operating bandwidth of the FFT is effectively divided into "bins", each of a width corresponding to the frequency resolution; the amplitude of the FFT output for each bin represents the average power spectral density of the sampled signal in the frequency range of the bin. Thus, if the frequency resolution of the FFT is increased, the FFT output will more accurately represent the actual spectrum of the signal. However, increasing the frequency resolution of the FFT requires a longer sample period, which can lead to undesirably increased latencies in the system.

The frequency of an RF signal can also be detected using analogue techniques. Typically, the RF signal is split into two paths of different length and the phase shift between them is measured using a phase-sensitive detector. The frequency of the signal can be deduced from the measured phase shift. However, this approach performs poorly if the RF signal contains more than one frequency (or, equivalently, if more than one RF signal is detected).

The frequency of an RF signal can also be measured by zero-crossing counting (as zero is crossed twice during each period of the signal). However, again, obtaining accurate measurements can result in long latencies, and performance is poor when the RF signal contains more than one frequency.

It would be advantageous to provide an RF frequency detector and a method of detecting RF frequency in which one or more of the aforementioned disadvantages is eliminated or at least reduced.

SUMMARY

Briefly and in general terms, the present disclosure provides apparatus and methods directed towards improving detection of an RF signal frequency by improving the resolution of apparatus and methods using FFTs. In particular, although not exclusively, the apparatus and methods are directed towards detection that is quick and reliable even when the RF signal contains more than one frequency.

A first aspect of this disclosure provides a method of detecting one or more frequencies in an RF signal by:

a. downconverting the RF signal;
b. performing a Fast Fourier Transform on the downconverted RF signal to measure the strength of the RF signal in each of a plurality of frequency bins each covering a range of frequencies;
c. identifying the frequency bin in which the RF signal is strongest;
d. comparing (i) the strength of the RF signal in a bin covering frequencies below the frequencies covered by the bin in which the RF signal is strongest with (ii) the strength of the RF signal in a bin above the frequencies covered by the bin in which the RF signal in strongest; and
e. calculating a frequency of the RF signal from the strength of the signal in the bin in which the RF signal is strongest and the strength of the RF signal in said bin above and/or below.

A second aspect of this disclosure provides a RF frequency detector configured to:

a. perform a Fast Fourier Transform on a down-converted RF signal to measure the strength of the RF signal in each of a plurality of frequency bins each covering a range of frequencies;
b. identify the frequency bin in which the RF signal is strongest;
c. compare (i) the strength of the RF signal in a bin covering frequencies below the frequencies covered by the bin in which the RF signal is strongest with (ii) the strength of the RF signal in a bin above the frequencies covered by the bin in which the RF signal in strongest; and
d. calculate a frequency of the RF signal from the strength of the signal in the bin in which the RF signal is strongest and the strength of the RF signal in said bin above and/or below.

A third aspect of this disclosure provides a radar warning receiver including an RF frequency detector according to the second aspect.

A fourth aspect of this disclosure provides an electronic warfare system including an RF frequency detector according to the second aspect.

It will be appreciated that features described in relation to one aspect of the present disclosure can be incorporated into other aspects of the present disclosure. For example, the RF frequency detector can incorporate any of the features described in this disclosure with reference to a method, and vice versa. Moreover, additional embodiments and aspects will be apparent from the following description, drawings, and claims. As can be appreciated from the foregoing and following description, each and every feature described herein, and each and every combination of two or more of such features, and each and every combination of one or more values defining a range, are included within the present disclosure provided that the features included in such a combination are not mutually inconsistent. In addition, any feature or combination of features or any value(s) defining a range may be specifically excluded from any embodiment of the present disclosure.

BRIEF DESCRIPTION OF THE DRAWINGS

Example embodiments will now be described by way of example only and with reference to the accompanying drawings, of which:

FIG. 1 is a schematic diagram of a system according to an example embodiment;
FIG. 2 is a plot of power spectral density as a function of frequency F following application of an FFT providing 9 frequency bins between 0 Hz and 275Hz, for a signal at (a) 95 MHz, (b) 100 MHz and (c) 105MHz;
FIG. 3 is a flow chart showing steps in an example method according to an example embodiment;
FIG. 4 is a plot of power spectral density as a function of frequency F following application of an FFT providing 9 frequency bins between 0 Hz and 275Hz, for a signal at 140 MHz at two successive steps (a) and (b) in the method of Fig. 3; and
FIG. 5 is a plot of power spectral density as a function of frequency F following application of an FFT providing 9 frequency bins between 0 Hz and 275Hz, for a two-component signal at 140 MHz and 50 MHz at three successive steps (a), (b) and (c) in the method of Fig. 3.

For convenience and economy, the same reference numerals are used in different figures to label identical or similar elements.

DETAILED DESCRIPTION

Embodiments are described herein in the context of approaches to improve detection of frequencies in an RF signal.

Those of ordinary skill in the art will realize that the following detailed description is illustrative only and is not intended to be in any way limiting. Other embodiments of the present invention will readily suggest themselves to such skilled persons having the benefit of this disclosure. Reference will be made in detail to implementations as illustrated in the accompanying drawings.

As previously stated, the first aspect is directed to a method of detecting one or more frequencies in an RF signal. The RF signal is downconverted. A Fast Fourier Transform is performed on the downconverted RF signal to measure the strength of the RF signal in each of a plurality of frequency bins each covering a range of frequencies. The frequency bin in which the RF signal is strongest is identified. The strength of the RF signal in a bin covering frequencies below the frequencies covered by the bin in which the RF signal is strongest is compared with the strength of the RF signal in a bin above the frequencies covered by the bin in which the RF signal in strongest. A frequency of the RF signal is calculated from the strength of the signal in the bin in which the RF signal is strongest and the strength of the RF signal in said bin above and/or below.

Radio frequencies are frequencies in the range extending from 3 KHz to 300 GHz. The radio frequencies may for example be radar frequencies, for example in the range 50 MHz to 100 GHz, for example in the L, S, C, X, $K_u$, K, or $K_a$ bands.

The method may further comprise the steps of: using the calculated frequency to calculate the expected strength of the RF signal in the plurality of frequency bins and comparing the expected strengths with the strengths measured by the FFT.

The method may further comprise deciding whether the expected strengths match the measured strengths sufficiently well for the frequency of the RF signal to be determined to be correct.

The method may further comprise, if the expected strengths do not so match the measured strengths:

a. identifying the frequency bin in which the difference between the expected strength and the measured strength is largest;

b. comparing (i) the strength of the RF signal in a bin covering frequencies below the frequencies covered by the bin in which the difference is largest with (ii) the strength of the RF signal in a bin above the frequencies covered by the bin in which the difference is largest; and

c. calculating a further frequency of the RF signal from the strength of the signal in the bin in which the difference is largest and the strength of the RF signal in said bin above and/or below.

The method may further comprise the steps of: using the calculated further frequency to calculate the expected strength of the RF signal in the plurality of frequency bins and comparing the expected strengths with the strengths measured by the FFT.

The method may further comprise deciding whether the expected strengths match the measured strengths sufficiently well for the frequency of the RF signal and the further frequency to be determined to be correct.

The method may further comprise repeating the above steps to produce a set of more than two frequencies, including the frequency of the RF signal and the further frequency, until the calculated expected strengths match the measured strengths sufficiently well for the set of frequencies to be determined to be correct.

It may be that the number of frequency bins is at least four times the number of frequencies in the RF signal (for example, if there are 2 frequencies in the signal there are preferably 8 or more bins). Having at least that number of frequency bins has been found to be desirable to reduce the latency of the measurement.

The plurality of frequency bins may together cover the spectrum of the RF signal.

The said bin above may be the bin immediately above the bin in which the RF signal is strongest. The said bin below may be the bin immediately below the bin in which the RF signal is strongest.

The Fast Fourier Transform may be performed using a Cooley-Tukey algorithm, for example a radix-2, radix-4 or another radix algorithm.

The strength of the signal in a frequency bin may be defined as the power spectral density of the signal in the frequency range covered by the bin.

The step of calculating a frequency of the RF signal may include concluding that the frequency of the RF signal is the centre frequency of the bin in which the RF signal is strongest if the strength of the RF signal in said bin above is equal to the strength of the RF signal in said bin below.

The step of calculating a frequency of the RF signal may include calculating the logarithm of the ratio of the magnitude of the strength of the RF signal in the bin above to the magnitude of the strength of the signal in the bin in which the RF signal is strongest. The step of calculating a frequency of the RF signal may include calculating the logarithm of the ratio of the magnitude of the strength of the RF signal in the bin below to the magnitude of the strength of the signal in the bin in which the RF signal is strongest.

The expected strengths of the RF signal may be calculated using an FFT of a signal having the calculated frequency/frequencies.

The comparison of the expected strengths with the strengths measured by the FFT may be done by subtracting one from the other.

The expected strengths may be decided to match the measured strengths if the expected strength plus 3dB is more than the measured strength.

As previously stated, a second aspect of this disclosure provides a RF frequency detector configured to perform a Fast Fourier Transform on a down-converted RF signal to measure the strength of the RF signal in each of a plurality of frequency bins each covering a range of frequencies. The frequency bin in which the RF signal is strongest is identified. The strength of the RF signal in a bin covering frequencies below the frequencies covered by the bin in which the RF signal is strongest is compared with the strength of the RF signal in a bin above the frequencies covered by the bin in which the RF signal in strongest. A frequency of the RF signal is calculated from the strength of the signal in the bin in which the RF signal is strongest and the strength of the RF signal in said bin above and/or below.

The RF frequency detector may be configured to carry out steps (a) to (d) of the second aspect set out above using one or more Field Programmable Gate Arrays (FPGAs) comprised in the detector and programmed to carry out those steps. Alternatively, the RF frequency detector may for example use one or more application specific integrated circuits (ASICs) or one or more microprocessors comprised in the detector and programmed to carry out steps (a) to (d).

The RF frequency detector may include a mixer arranged to mix the RF signal with a local oscillator signal to convert the RF signal to a lower frequency band, e.g. a band that is suitable for electronics configured to carry out steps (a) to (d).

The RF frequency detector may include an analogue-to-digital converter arranged to receive the down-converted RF signal as an analogue signal, for example from the mixer, and to digitise said analogue signal.

Example embodiments provide a system that allows the frequency of an incident RF signal to be determined with a high resolution, high dynamic range and low latency. The system proposed also offers a degree of robustness when subjected to signals with more than a single frequency content. Such a system is expected to find potential applications in systems that are required to respond to a complex, varying RF spectrum, for example a radar warning receiver (RWR) or electronic warfare system (EW).

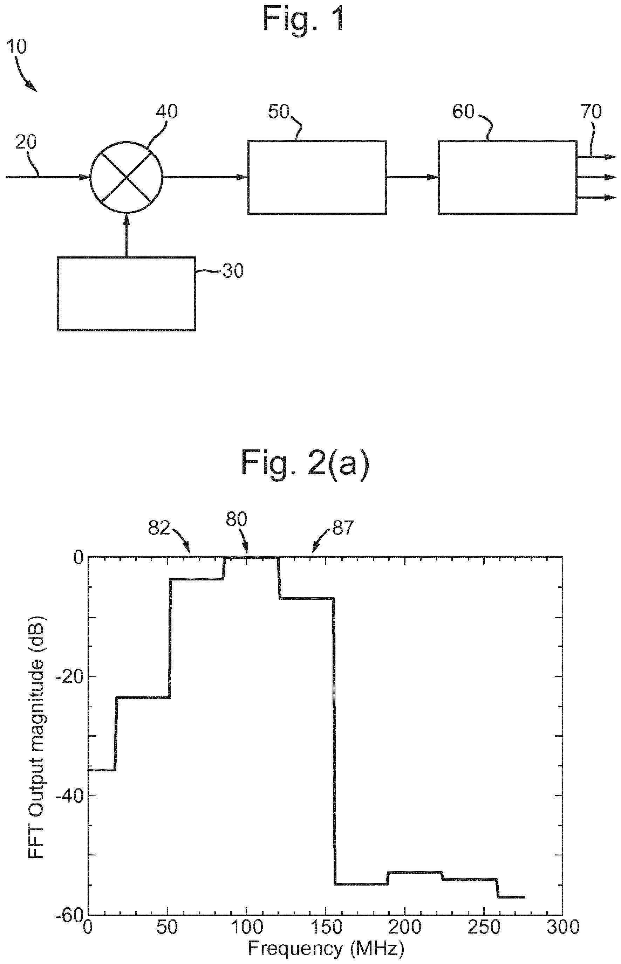

In an example embodiment, an RF down converter 10 (Fig. 1), including an unbalanced to balanced converter necessary for the ADC used, is utilised to bring an analogue RF signal 20 into the sampling range of a high-end analogue to digital converter (ADC) 50. The ADC, such as part ADS5401 manufactured by Texas Instruments is chosen to have a low latency (in this example about 50 ns, because it has short pipelining), high sampling rate to provide high spectral resolution (in this example 500 million samples per second) and high bit count to provide a high dynamic range (in this example 12 bits). Thus, the RF signal 20 is mixed in a mixer 40 with a signal from a local oscillator 30 to down-convert the signal to the operating frequency range of the ADC 50. The ADC 50 converts the down-converted signal from analogue to digital. The digitised signal from the ADC 50 passes to a field programmable gate array (FPGA) 60. In this example, the FPGA is a Kintex-7 by Xilinx Inc. (www.xilinx.com). The FPGA is configured to implement an FFT, which in this example is implemented using a radix-2 approach.

The frequency of the RF signal 20 can be approximately determined by identifying the frequency bin in the FFT output that has the highest power spectral density. However, the resolution of that determination is, in prior-art methods, limited by the frequency resolution of the FFT. As discussed above, the resolution can be increased, but at the expense of increased system latency.

The inventors have recognised that an improved frequency resolution can be obtained by considering the power spectral density in FFT bins either side of the main frequency bin, i.e. the frequency bin with the highest power spectral density. When the incident RF signal frequency is central in the main bin, the side-lobe power (i.e. the power spectral density in adjacent bins) will be symmetric. Deviations in the frequency either side of the bin centre will result in the sidelobes being weighted to one side or the other.

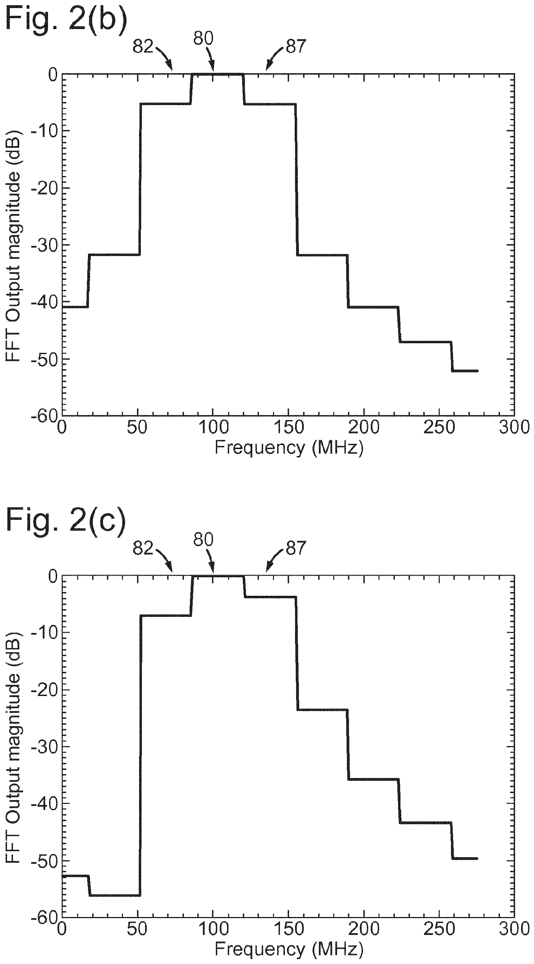

That phenomenon is illustrated in Fig. 2, which shows the average power spectral density in 9 bins dividing the signal spectrum between 0 and 275 MHz. The 2nd to 8th bins are approximately 34 MHz wide; in this example, the 1st bin and the 9th bin are each half as wide as the other bins (that is a result of the particular choices made in implementing the FFT in this example, and is not significant). Note in particular that there is a bin 80 (the 4th) centred around 100 MHz, running from approximately 85 MHz to approximately 120 MHz.

In Fig. 2(a), the FFT acts on a signal centred at 95Mhz, i.e. within the 85 MHz to 120 MHz bin 80 but below its 100 MH centre frequency. Consequently, there is more power in the signal spectrum at frequencies below the 85 MHz lower edge of the bin 80 than at frequencies above the 120 MHz upper edge of the bin 80, and so the bin 82 to the left of the main bin 80 (i.e. the 3rd bin) has a higher average spectral density than the bin 87 to the right of the main bin 80 (i.e. the 5th bin).

In Fig. 2(b), the FFT acts on a signal centred at 100 MHz, i.e. approximately at the centre frequency of the 85 MHz to 120 MHz bin 80. Consequently, the power in the signal spectrum is approximately the same at frequencies below the 85 MHz lower edge of the bin 80 as at frequencies above the 120 MHz upper edge of the bin 80, and so the bin 82 to the left of the main bin 80 (i.e. the 3rd bin) and the bin 87 to the right of the main bin 80 (i.e. the 5th bin) have the approximately the same average spectral density.

In Fig. 2(c), the FFT acts on a signal centred at 105 Mhz, i.e. within the 85 MHz to 120 MHz bin 80 but above its 100 MHz centre frequency. Consequently, there is less power in the signal spectrum at frequencies below the 85 MHz lower edge of the bin 80 than at frequencies above the 120 MHz upper edge of the bin 80, and so the bin 82 to the left of the main bin 80 (i.e. the 3rd bin) has a lower average spectral density than the bin 87 to the right of the main bin (i.e. the 5th bin).

The inventors have noted that the relationship between (i) the power in the adjacent bins and the power in the main bin and (ii) the frequency offset of the signal compared to the bin centre frequency, is logarithmic. That information enables a refined estimation of the actual RF frequency of the signal to be made. In the example embodiment, a gradient of $\pm 4.16$MHz per dB is observed with an intercept crossing of -6dB, such that the frequency offset $\Delta F$ is determined as follows:

$$\Delta F = -4.16 \left[ 6.0 + 10 log_{10} \left( \frac{mag_{bin_{X-1}}}{mag_{bin_X}} \right) \right]$$

$$\Delta F = 4.16 \left[ 6.0 + 10 log_{10} \left( \frac{mag_{bin_{X+1}}}{mag_{bin_X}} \right) \right]$$

Where $mag_{bin_X}$ means the magnitude of the signal in the xth bin.

As an example, if the bin characteristics are: $bin_{X-1}$ = 75MHz, with 50MHz bandwidth (50 to 100MHz coverage); $bin_X$ = 125MHz, with 50MHz bandwidth (100 to 150MHz coverage); $bin_{X+1}$ = 175MHz, with 50MHz bandwidth(150 to 150MHz coverage), and a signal is observed with the following magnitude: $mag_{bin_{X-1}}$: -33.6 dBm; $mag_{bin_X}$: -30.0 dBm; $mag_{bin_{X+1}}$:-38.4 dBm, using the above equations (note the values are already in 10log10) this yields -9.984 MHz & -9.984 MHz, giving a resultant frequency of 125 MHz - 9.984 MHz = -115MHz.

Furthermore, the method can be extended to enable detection of signals having a plurality of frequencies. A measure and predict cycle can be used. Based on the measurement of the greatest magnitude signal, the side-lobe pattern can be predicted. The prediction can be used as a mask. If no further frequencies are present then the measured side-lobe pattern and the predicted side-lobe pattern will be similar. If the patterns are different then it can be inferred that further frequencies are present and the method can be reapplied on the difference between the measured and predicted patterns.

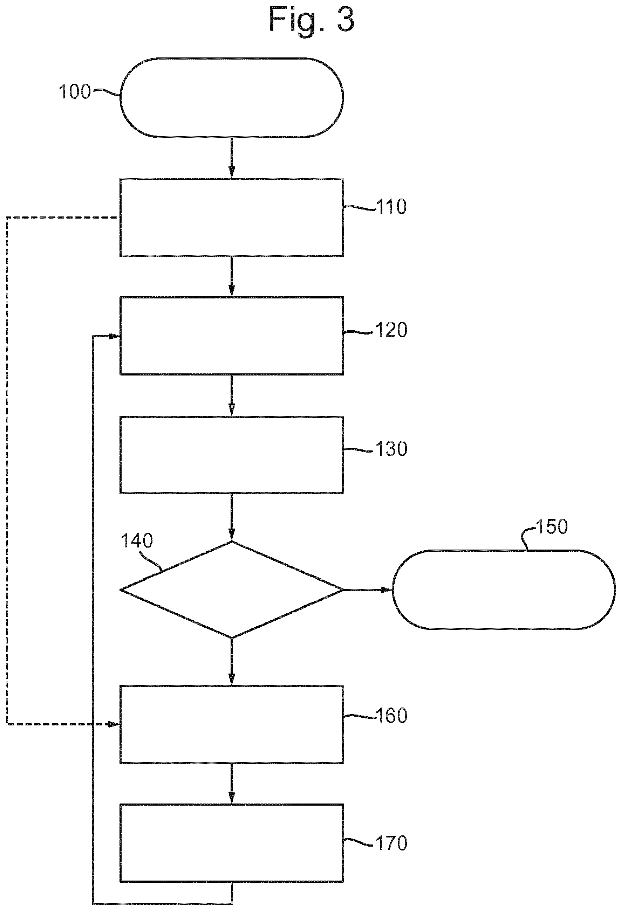

Fig. 3 shows steps in an example method. The method starts (step 100) with the digitised signal being received by the FPGAs 60. The FPGAs 60 perform an FFT 110 on the digitised signal. On the first iteration of the method, no frequencies have been identified in the signal, and so the method passes directly to step 160, discussed below. In subsequent iterations, there will be a list of at least one previously identified frequency. Using the list of previously identified frequencies, the FFT side-lobe pattern is predicted by the FPGAs (step 120). (In this example, a 3dB margin of error is added to the predicted side-lobe pattern to form an adjusted predicted side-lobe pattern.) The (adjusted) predicted side-lobe pattern is subtracted from the measured side-lobe pattern (i.e. the digitised signal) (step 130). The method then checks whether or not subtraction results in a negative average spectral power density for all bins (step 140). If yes, all signals have been identified and the method halts (step 150). If no, the bin with the largest average spectral density following the subtraction is identified (step 160). The logarithmic relationship between the average spectral power density in that bin and the average spectral power density in the bins adjacent to that bin is used, as described above, to calculate the frequency offset of the signal compared to the bin centre frequency, to provide an improved estimate of the frequency generating the maximum and that frequency is added to the list of frequencies (step 170). The method then repeats from step 120, predicting the side-lobe pattern based on the list now including the most recently identified frequency.

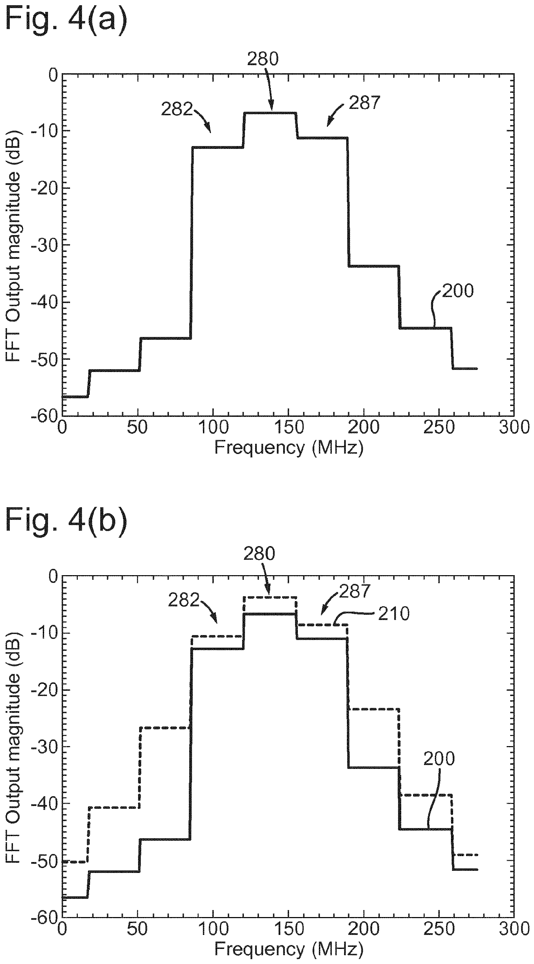

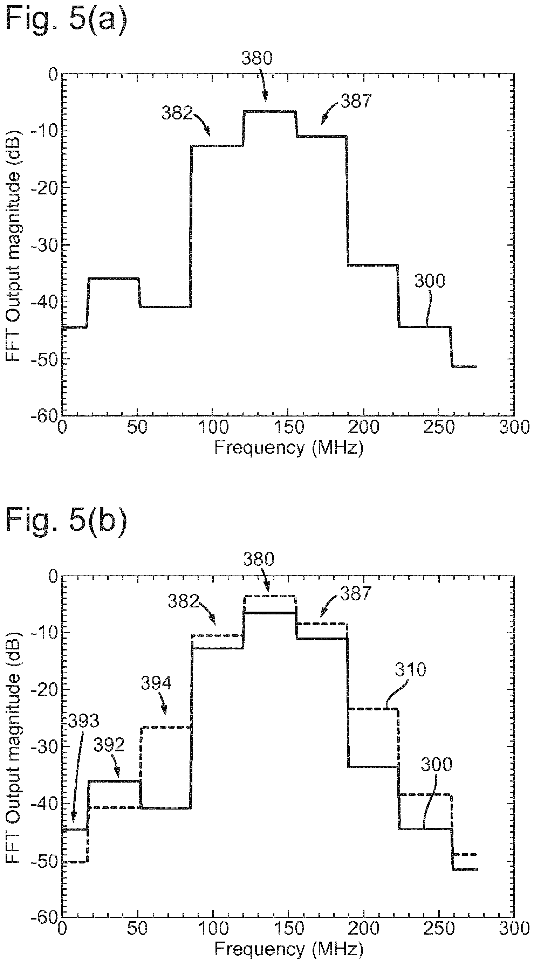

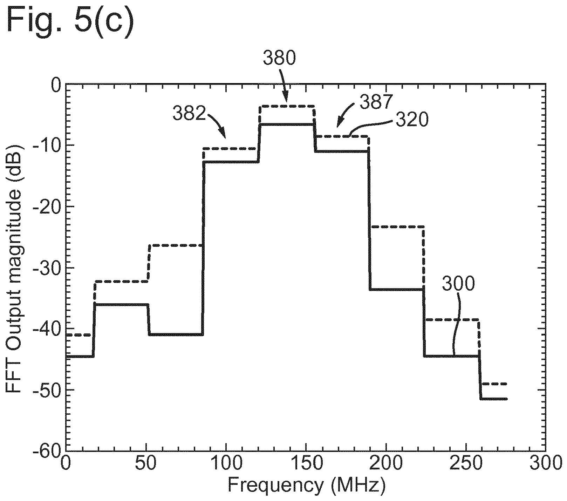

Examples of use of the method of Fig. 3 are shown in Figs. 4 and 5.

In Fig. 4, the RF signal has a frequency of 140MHz. The results of the FFT (step 110) are shown in Fig. 4(a) as trace 200. No prediction of expected side-lobes (step 120) is possible, since no frequencies have yet been identified. The method therefore skips to step 160. The bin with the maximum signal is the 120 MHz to 155MHz bin 280. The magnitude of the signal in the neighbouring bins 282, 287 is used to refine the resolution of the estimate of the signal frequency to 140 MHz (step 170). The estimate of the signal frequency is used to predict expected signal 210 (step 120) (Fig. 4(b)). Subtraction of the predicted signal 210 from the measured signal 200 (step 130) gives all bins negative (step 140). The method terminates (step 150).

In Fig. 5, the RF signal has two components, at 50 MHz and140 MHz. The results of the FFT (step 110) are shown in Fig. 5(a) as trace 300. No prediction of expected side-lobes (step 120) is possible, since no frequencies have yet been identified. The method therefore skips to step 160. The bin with the maximum signal is the 120 MHz to 155MHz bin 380. The magnitude of the signal in the neighbouring bins 382, 387 is used to refine the resolution of the estimate of the signal frequency to 140 MHz (step 170). The estimate of the signal frequency is used to predict the expected signal 310 (step 120) (Fig. 5(b)). After subtraction of the predicted signal 310 from the measured signal 300 (step 130), some of the bins 392, 393 remain positive (step 140). The measured second FFT peak is identified in the 20MHz to 50 MHz bin 392 (step 160). The magnitude of the signal in the neighbouring bins 393, 394 is used to refine the resolution of the estimate of the signal frequency to 40 MHz and that frequency is added to the list of frequencies (step 170). The signal frequencies (140 MHz and 40 MHz) are used to generate a second predicted signal 320 (Fig. 5(c)) (step 120). Subtraction of the predicted signal 320 from the measured signal 300 (step 130) gives all bins negative (step 140), so the method terminates (step 150).

While the present disclosure has been described and illustrated with reference to particular embodiments, it will be appreciated by those of ordinary skill in the art that the disclosure lends itself to many different variations not specifically illustrated herein.

Where, in the foregoing description, integers or elements are mentioned that have known, obvious, or foreseeable equivalents, then such equivalents are herein incorporated as if individually set forth. Reference should be made to the claims for determining the true scope of the present disclosure, which should be construed so as to encompass any such equivalents. It will also be appreciated by the reader that integers or features of the disclosure that are described as optional do not limit the scope of the independent claims. Moreover, it is to be understood that such optional integers or features, while of possible benefit in some embodiments of the disclosure, may not be desirable, and can therefore be absent, in other embodiments.

**Claims**

1.  A method of detecting one or more frequencies in an RF signal, the method comprising the steps:

    a. downconverting the RF signal;
    b. performing a Fast Fourier Transform on the downconverted RF signal to measure the strength of the RF signal in each of a plurality of frequency bins each covering a range of frequencies;
    c. identifying the frequency bin in which the RF signal is strongest;
    d. comparing (i) the strength of the RF signal in a bin covering frequencies below the frequencies covered by the bin in which the RF signal is strongest with (ii) the strength of the RF signal in a bin above the frequencies covered by the bin in which the RF signal in strongest; and
    e. calculating a frequency of the RF signal from the strength of the signal in the bin in which the RF signal is strongest and the strength of the RF signal in said bin above and/or below.

2.  The method of claim 1 further comprising the steps of: using the calculated frequency to calculate the expected strength of the RF signal in the plurality of frequency bins and comparing the expected strengths with the strengths measured by the FFT.

3.  The method of claim 2, wherein the comparison of the expected strengths with the strengths measured by the FFT is done by subtracting one from the other.

4.  The method of claim 2 or claim 3 further comprising deciding whether the expected strengths match the measured strengths sufficiently well for the frequency of the RF signal to be determined to be correct.

5.  The method of claim 4, wherein the expected strengths are decided to match the measured strengths if the expected strength plus 3dB is more than the measured strength.

6.  The method of claim 4 or claim 5 further comprising, if the expected strengths do not so match the measured strengths:

    I. identifying the frequency bin in which the difference between the expected strength and the measured strength is largest;
    II. comparing (i) the strength of the RF signal in a bin covering frequencies below the frequencies covered by the bin in which the difference is largest with (ii) the strength of the RF signal in a bin above the frequencies covered by the bin in which the difference is largest; and
    III. calculating a further frequency of the RF signal from the strength of the signal in the bin in which the difference is largest and the strength of the RF signal in said bin above and/or below.

7.  The method of claim 6, further comprising the steps of: using the calculated further frequency to calculate the expected strength of the RF signal in the plurality of frequency bins and comparing the expected strengths with the strengths measured by the FFT.

8.  The method of claim 7 further comprising deciding whether the expected strengths match the measured strengths sufficiently well for the frequency of the RF signal and the further frequency to be determined to be correct.

9.  The method of claim 8 further comprising repeating the steps of the method to produce a set of frequencies, including the frequency of the RF signal and the further frequency, until the calculated expected strengths match the measured strengths sufficiently well for the set of frequencies to be determined to be correct.

10. A method as claimed in any preceding claim, in which the said bin above is the bin immediately above the bin in which the RF signal is strongest.

11. A method as claimed in any preceding claim, in which the said bin below is the bin immediately below the bin in which the RF signal is strongest.

12. A method as claimed in any preceding claim, in which the step of calculating a frequency of the RF signal includes calculating the logarithm of the ratio of the magnitude of the strength of the RF signal in the bin above and/or below to the magnitude of the strength of the signal in the bin in which the RF signal is strongest.

**13.** A RF frequency detector configured to:

a. perform a Fast Fourier Transform on a down-converted RF signal to measure the strength of the RF signal in each of a plurality of frequency bins each covering a range of frequencies;

b. identify the frequency bin in which the RF signal is strongest;

c. compare (i) the strength of the RF signal in a bin covering frequencies below the frequencies covered by the bin in which the RF signal is strongest with (ii) the strength of the RF signal in a bin above the frequencies covered by the bin in which the RF signal in strongest; and

d. calculate a frequency of the RF signal from the strength of the signal in the bin in which the RF signal is strongest and the strength of the RF signal in said bin above and/or below.

**14.** A radar warning receiver including an RF frequency detector according to claim 13.

**15.** An electronic warfare system including an RF frequency detector according to claim 14.

# Fig. 1

# Fig. 2(a)

# Fig. 2(b)

# Fig. 2(c)

# Fig. 3

## Fig. 4(a)

## Fig. 4(b)

## Fig. 5(a)

## Fig. 5(b)

# Fig. 5(c)

Europäisches
Patentamt

European
Patent Office

Office européen
des brevets

# EUROPEAN SEARCH REPORT

Application Number

EP 18 27 5061

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHAUDHARI ANUJA ET AL: "Frequency estimator to improve short range accuracy in FMCW radar", 2015 INTERNATIONAL CONFERENCE ON ADVANCES IN COMPUTING, COMMUNICATIONS AND INFORMATICS (ICACCI), IEEE, 10 August 2015 (2015-08-10), pages 640-644, XP033217636, DOI: 10.1109/ICACCI.2015.7275682 ISBN: 978-1-4799-8790-0 [retrieved on 2015-09-24] | 1,10-15 | INV. H04B17/318 G01R23/00 |
| A | * section I * * section II * * section III * | 2-9 | |
| X | DJUKANOVIC SLOBODAN: "Sinusoid frequency estimator with parabolic interpolation of periodogram peak", 2017 40TH INTERNATIONAL CONFERENCE ON TELECOMMUNICATIONS AND SIGNAL PROCESSING (TSP), IEEE, 5 July 2017 (2017-07-05), pages 470-473, XP033232234, DOI: 10.1109/TSP.2017.8076030 [retrieved on 2017-10-19] | 1,10-15 | |
| A | * section I * * section II * | 2-9 | |

-----

-/--

| | | TECHNICAL FIELDS SEARCHED (IPC) |
|---|---|---|
| | | H04B G01R |

The present search report has been drawn up for all claims

| Place of search | Date of completion of the search | Examiner |
|---|---|---|
| The Hague | 25 September 2018 | Riposati, Benedetto |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 18 27 5061

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MALCOLM D MACLEOD: "Fast Nearly ML Estimation of the Parameters of Real or Complex Single Tones or Resolved Multiple Tones", IEEE TRANSACTIONS ON SIGNAL PROCESSING, IEEE SERVICE CENTER, NEW YORK, NY, US, vol. 46, no. 1, 1 January 1998 (1998-01-01), XP011058014, ISSN: 1053-587X * page 141, left-hand column, lines 21-33 * * page 143, right-hand column, lines 19-33 * * page 146, left-hand column, lines 13-34 * ----- | 1-15 | |

TECHNICAL FIELDS
SEARCHED      (IPC)

The present search report has been drawn up for all claims

| Place of search | Date of completion of the search | Examiner |
|---|---|---|
| The Hague | 25 September 2018 | Riposati, Benedetto |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
 
& : member of the same patent family, corresponding
   document